# EUROPEAN PATENT SPECIFICATION

(11) **EP 3 522 283 B1**
(45) Date of publication and mention of the grant of the patent: **27.05.2020**
(21) Application number: 19155573.9
(22) Date of filing: 05.02.2019
(51) Int. Cl.: H01M 10/05, H01M 10/058, H01M 10/0565, H01M 6/18

(54) **POLYELECTROLYTE COMPOSITION AND A PROCESS FOR ITS MAKING**
POLYELEKTROLYTZUSAMMENSETZUNG UND VERFAHREN ZU DEREN HERSTELLUNG
COMPOSITION DE POLYÉLECTROLYTE ET SON PROCÉDÉ DE FABRICATION

(30) Priority: 06.02.2018 EP 18155323
(43) Date of publication of application: 07.08.2019
(73) Proprietor: RISE Acreo AB, 164 25 Kista (SE)
(72) Inventor: SANDBERG, Mats, 602 17 NORRKÖPING (SE); SAWATDEE, Anurak, 582 34 LINKÖPING (SE); LINDERHED, Ulrika, 603 37 NORRKÖPING (SE)
(74) Representative: AWA Sweden AB

(56) References cited:
- WO-A1-2012/136781
- WO-A1-2013/068185
- JP-A- 2002 226 737

## Description

### Technical Field of the Invention

The present invention relates to a polyelectrolyte composition, to a method of producing the composition, to an electrochemical cell comprising the polyelectrolyte composition and to use of the polyelectrolyte composition.

### Background of the Invention

There are often several problems to overcome when an electrochemical cell is manufactured by printing and coating.with depositing an electrolyte film by printing or coating a electrochemical cell. Examples of such electrochemical cells are e.g. given in US 2004/0211989, wherein both lateral and vertical electrochemical cells are described; as well as in US 2012/0081775. In vertical cells the electrolyte ink should after curing form an electrolyte layer that connects the two electrodes electrolytically, but not electronically, that is, the electrolyte should form a layer electronically separating the bottom electrode from the top electrode and it should preferably or ideally be free from pin-holes, which may cause short circuit of the device. Further, the printed film should preferably or ideally have a homogenous thickness. It should also be over-printable or coatable by a layer forming the top electrode.

It is problematic that conventional inks does not meet one of more of these requirements today. WO2013/068185 discloses printable electrolyte compositions based on poly(diallyldimethylammonium chloride) (PDADMA-CI).

Therefore, there is a need for an electrolyte composition, that may be used for printing purposes, which solves or at least mitigates one or more of the problems set out above.

### Summary of the Invention

The present invention thus solves one or more of the problems set out above by paving the way for replacing conventional water-based polyelectrolyte inks with polyelectrolyte in a solvent mixture where water is a minority component and/or with polyelectrolyte inks which are essentially water-free.

These and other objects are achieved by providing according to a first aspect of the present invention a process for manufacturing a printable composition comprising the following steps:
I) providing an aqueous solution of one or more polyelectrolytes, wherein the polyelectrolyte is a quaternary cationic polyelectrolyte, preferably PDADMAC, most preferred a low molecular PDADMAC, especially preferred an ultra-low molecular PDADMAC,
II) mixing one or more diols with said aqueous solution, wherein preferably the diol is a diol that has a carbon chain length of from 2 to 5, most preferred propylene glycol,
III) removing water either before or after step II), wherein the water removal is achieved preferably through evaporation, solvent exchanging or freeze-drying or a combination thereof, thus providing and intermediary composition,
wherein the water content of the printable composition is from 0.001 to 15% (w/w), preferably from 0.01 to 12 % (w/w), most preferred from 0.1 to 10 % (w/w), especially preferred from 1 to 7 % (w/w).

According to a second aspect of the present invention there is also provided a printable composition comprising:
a) one or more polyelectrolytes, wherein the polyelectrolyte is a a quaternary cationic polyelectrolyte, most preferred PDADMAC, especially preferred a low molecular PDADMAC, particularly preferred an ultra-low molecular PDADMAC,
b) one or more diols, preferably a diol that has a carbon chain length of from 2 to 5, most preferred a propylene glycol, and
c) water, wherein said water content of said composition is from 0.001 to 15% (w/w), preferably from 0.01 to 12 % (w/w), most preferred from 0.1 to 10 % (w/w), especially preferred from 1 to 7 % (w/w).

The ranges set out above, i.e. from 0.001 to 15% (w/w), from 0.01 to 12 % (w/w), 0.1 to 10 % (w/w) and 1 to 7 % (w/w) may be differently preferred depending on the route used for removing water as set out in step III) above.

Said printable composition may additionally or alternatively be characterized by certain rheology characteristics. In the case of screen printing the viscosity of said composition may preferably be higher than 0.3 Pas.

According to a third aspect of the present invention there is also provided a process for the manufacture of an electrochemical cell comprising the following steps:
providing a first electrode (10); a second electrode (20); and a printable composition according to the first or second aspect, wherein the printable composition is arranged in ionic contact with both said first and second electrode, and
wherein the first electrode, the second electrode and/or the printable composition is preferably provided by means of printing.

According to a fourth aspect of the present invention there is also provided use of a printable composition according to the first aspect for printing an electrolyte layer in ionic contact with at least a first electrode (10) and a second electrode (20) in an electrochemical cell.

According to a fifth aspect of the present invention there is also provided an electrochemical cell, comprising a first and a second electrode and an electrolyte layer in ionic contact with both said first and second electrodes, wherein said electrolyte layer comprises an electrolyte composition according to the first aspect.

Said compositions may further also be useful for other purposes than for printing purposes. Thus there is also provided a process for manufacturing a composition comprising the following steps:
I) providing an aqueous solution of one or more polyelectrolytes, wherein the polyelectrolyte is a quaternary cationic polyelectrolyte, preferably PDADMAC, most preferred a low molecular PDADMAC, especially preferred an ultra-low molecular PDADMAC,
II) mixing one or more diols with said aqueous solution, wherein preferably the diol is a diol that has a carbon chain length of from 2 to 5, most preferred propylene glycol,
III) removing water either before or after step II), wherein the water removal is achieved preferably through evaporation, solvent exchanging or freeze-drying or a combination thereof, thus providing and intermediary composition,
wherein the water content of the printable composition is from 0.001 to 15% (w/w), preferably from 0.01 to 12 % (w/w), most preferred from 0.1 to 10 % (w/w), especially preferred from 1 to 7 % (w/w).

In addition there is also provided a composition comprising:
a) one or more polyelectrolytes, preferably a quaternary cationic polyelectrolyte, most preferred PDADMAC, especially preferred a low molecular PDADMAC, particularly preferred an ultra-low molecular PDADMAC,
b) one or more diols, preferably a diol that has a carbon chain length of from 2 to 5, most preferred a propylene glycol, and
c) water, wherein said water content of said composition is from 0.001 to 15% (w/w), preferably from 0.01 to 12 % (w/w), most preferred from 0.1 to 10 % (w/w), especially preferred from 1 to 7 % (w/w).

The one or more polyelectrolytes may be referred to as the 'active material' in the printable composition according to the first and the second aspect of the present invention. The purpose of the one or more polyelectrolytes is e.g. to provide ions and ion mobility sufficient for the composition to function as an electrolyte in an electrochemical cell. The one or more polyelectrolytes provides mobile ions and the whole composition provides mobility for ions to create electrolytic connectivity between the electrodes in ionic contact with the electrolyte in an electrochemical device. This means that the ion transporting paths in the electrolyte should be sufficient to provide ion transport for the electrochemical switching of the electrodes by means of electrochemical reaction.

The one or more polyelectrolytes is for example a polycationic material, like cationic polymers having quaternized nitrogen atoms, for example quaternized ammonium groups.

Examples of a polyelectrolyte comprising quaternized nitrogen atoms are polymers termed polyquaternium by the international nomenclature of cosmetic ingredients. One example of a polyquaternium is polyquaternium-16, with the chemical name poly[(3-methyl-1 -vinylimidazolium chloride)-co-(1-vinylpyrrolidone)]. Another example is polyquaternium-6, with the chemical name poly(diallyldimethylammonium chloride) (shortened PDADMC-CI or PDADMAC, which acronyms are used interchangebly in this context). Preferred is PDADMAC, especially preferred a low molecular PDADMAC, such as a PDADMAC that has an average M_{w} under 1000000, such as from 1000 to 1000000, particularly preferred is an ultra-low molecular PDADMAC. Said ultra-low molecular PDADMAC further has an average M_{w} under 100000, preferably with an average M_{w} from 1000 to 100000.

It is intended throughout the present description that the expression "one or more diols" embraces any diol or diols useful in an electrolyte composition, which composition is especially useful for printing purposes. The one or more diols may have a carbon chain length which is e.g. at least from 2, 4, 6 or 8; and/or which is e.g. at most 15, 13, 11, 9 or 7. E.g. said one or more diols may have a carbon chain length from 3 to 10, or from 2 to 5. Additionally or alternatively said one or more diols advantageously has a straight carbon chain, also said chain is also preferably without any benzene rings or other ring systems. Additionally or alternatively said one or more diols advantageously is not present in a polymerized form but instead as low molecular molecules. Examples of such diols are glycols. One preferred diol is propylene glycol. The length of the carbon chain of the diol is preferably relatively short for the purposes of the present invention. The OH-groups are preferably located in close proximity of oneanother in said diols.

It is intended throughout the present description that the expression "polymerizable molecules" embraces any polymerizable molecules useful in an electrolyte composition, which is especially useful for printing purposes. Preferably said molecules are (meth-) acrylates. (Meth) acrylate is intended to have its standard meaning in this context i.e. acrylate and/or methacrylate. Examples of said (meth-) acrylates are polyether (meth-) acrylates or urethane (meth-) acrylates.

It is intended throughout the present description that the expression "initiator molecules" embraces any initiator molecules useful in an electrolyte composition, which composition is especially useful for printing purposes, preferably also comprising polymerizable molecules as set out above. Especially they are useful for curing purposes, after printing in compositions also comprising polymerizable molecules. In particular said initiator molecules may be for radical polymerization that can be triggered by actinic irradiation. Examples of said initiators are 2-hydroxy-4'-(2-hydroxyethoxy)-2-methylpropiophenone) which may be obtained from Sigma Aldrich with the name Irgacure® 2959, 2,4,6-trimethylbenzoyl diphenyl phosphine oxide which may be obtained from BASF with the name Lucirin® TPO and difunctional - α-hydroxy ketones, such as the ones named Esacure™ available from Lamberti SA, or lithium phenyl(2,4,6-trimethylbenzoyl)phosphinate, available form Tokyo Chemical Industry, Co. Ltd, Japan.

It is intended throughout the present description that the expression "intermediary composition" consists of (i.e. comprises only) one or more polyelectrolytes, one or more diols and water. In particular said water is present in a small amount, and thus preferably said water is a minor component. It may also be so that water is a minor component in the solvent mixture (diol and water) or it may also be the minor component in the composition as set out above. It may also be so that there are more water than diol in the solvent mixture, but of course as there are much more in the composition, water will still be a minor component if looking at said composition as a whole.

The intermediary composition may e.g. be provided and marketed as such, or after its making one or more additives may be added to said intermediary composition to provide the desired properties of the polyelectrolyte(s).

Said intermediary composition may as such e.g. be produced at one facility whereas the composition comprising one or more additives may be produced at a different facility, or the additives may e.g. be added into the same vessel as the intermediary composition was produced in.

In order to obtain desired properties of said compositions, one or more additives may be added to the intermediary composition or in the process for preparing said intermediary composition. According to a preferred embodiment, one or more curing enhancing agents are added, which curing may be performed using different techniques. Said compositions may e.g. be UV-curable or solvent drying as known in the art. This/these curing enhancing agent(s) enable(s) the hardening of a liquid material into an essentially solid material or solidified material. This hardening into an essentially solid material or solidified material, provides a stability that allows for over-printing, and thus the provision of an additional layer.

According to a preferred embodiment said composition also comprises:
e) one or more curing enhancing agents, preferably selected from the group comprising one or more solvent drying binders, one or more polymerizable molecules and one or more initiator molecules.

According to a preferred embodiment said one or more curing enhancing agents is (are) either:
f) one or more solvent drying binders, preferably a polyvinyl butyral, most preferred a polyvinyl butyral with a low molecular weight, or
g)
   - two or more polymerizable molecules, and
   - one or more initiator molecules.

Said solvent drying binder may be present in the composition in an amount of from 4 to 12 wt%, such as from 6 to 10 wt%, when both amounts are added in a solvent, or from 1 to 3 wt%, such as from 1.5 to 2.5 wt%, when added in pure form. Said solvent drying binder solidifies and strengthens the printed electrolyte when the solvent evaporates.

According to a preferred embodiment of the first aspect only steps I, II and III are performed thereby providing an intermediary composition, further comprising the step of adding and mixing one or more additional components to said intermediary composition, wherein said components are selected from the group:
- polymerizable molecules,
- initiator molecules,
- processing aid agents,
- pigments,
- plasticizers,
- accelerators,
- solvent drying binders, and
- compatibilizing agents.

Thus in said embodiment said intermediary composition consists of three components, before adding one or more additional components, i.e. polyelectrolyte, diol and water.According to a preferred embodiment, the composition after having one or more additional components added, besides one or more polyelectrolytes, one or more diols and water, has a water content from 2 to 6 % (w/w).

According to a preferred embodiment, the one or more polyelectrolytes is present in a range from 5 to 50 %, preferably 28 to 30 % (w/w) and/or the one or more diols is present in a range from 50 to 95 %, preferably 60 to 70 % (w/w).

According to a preferred embodiment the composition also comprises:
a hydroxyl carboxylic acid, preferably a hydroxyl carboxylic acid with a carbon chain of from 1 to 6, and wherein said hydroxyl carboxylic acid, is optionally selected from the group comprising 2-hydroxy-2-methylbutyric acid, 2,2-bis (hydroxymethyl) butyric acid or a combination thereof.

According to a preferred embodiment the composition also comprises as said:
one or more solvent drying binders, preferably a polyvinyl butyral, especially preferred a polyvinyl butyral with a low molecular weight. Said polyvinyl butyral may have a weight average molecular weight (Mw) which is below 100000, preferaby in a range of from 1000 to 100000, most preferred below 40000, especially preferred below 20000. If using a polyvinyl butyral with a low molecular weight, the range of the weight average molecular weight (Mw) may befrom 10000 to 20000.

Polyvinyl butyrals (PVB) are typically manufactured from the coupling reaction of polyvinyl alcohol (PVOH) and butyraldehyde. The polyvinyl alcohol is in turn obtained by hydrolysis of polvinyl acetate (PVAc). The composition of the PVB depends on the degree of hydrolysis of the original PVAc, and the conditions of the reaction between the PVOH, resulting in various amounts of butyral-, hydroxyl- and acetate groups. PVB are for example supplied by Eastman under brandname Saflex, or supplied by Kuraray Co. Ltd. under the tradename Mowital. A PVB with a low molecular weight, which is preferred, is Mowital B16H. Said Mowital B16H has a molecule weight distribution of a weight average molecular weight (Mw) of about 16000.

Said PVB may further, when added into said composition, be present in a solvent, such as DBE (Dibasic ester mixture; which is a mixture of dimethyl adipate and dimethyl glutarate). PVB is soluble in a number of different solvents, and these may e.g. be alcohols such as ethanol, iso-propanol, n-butanol or diacetone alcohol, and esters such as methyl, ethyl or n-butyl acetates and DBE, or mixtures thereof, wherein DBE is one specific example thereof.

According to a preferred embodiment the composition also comprises:
- polymerizable molecules, and/or
- one or more initiator molecules.

According to a preferred embodiment the composition further comprises a processing aid agent, which preferably is an aliphatic carboxylic acid with a low melting point, i.e. a melting point below room temperature, which means a melting point below 25 °C, most preferred said agent is lactic acid, especially preferred DL-lactic acid.

It is intended throughout the present description that the expression "processing aid agent" embraces any aliphatic carboxylic acid that may help to keep a surface layer intact during a heat treatment. Thus the interaction between the polyelectrolyte and said diol is enhanced by using said agent. Preferably said acid is an aliphatic carboxylic acid with a low melting point, i.e. a melting point below room temperature. Said acid may be valeric acid, hexanoic acid, hydroxybutyric acid and lactic acid (2-hydroxypropionic acid), or a combination thereof. Preferably said acid is lactic acid, most preferred lactic acid in it DL-form, thus denoted DL-lactic acid.

According to a preferred embodiment, the composition further comprises:
- one or more pigments, and/or
- one or more plasticizers, and/or
- one or more accelerators, wherein said accelerator preferably is triethanolamine.

According to a preferred embodiment, the polymerizable molecules are polyether (meth-) acrylates or urethane (meth-) acrylates or a combination thereof.

According to a preferred embodiment, the one or more initiator molecules, such as photo-initator molecules, may be selected from the group consisting of aromatic ketones, diaromatic diketones or phosphines or combinations thereof, preferably they are selected form the group consisting of 2-hydroxy-4'-(2-hydroxyethoxy)-2-methylpropiophenone), 2, 4,6-trimethylbenzoyl diphenyl phosphine oxide or difunctional - α-hydroxy ketone or combinations thereof. To the aromatic ketones the following group of compounds belong:1-hydroxycyclohexyl-1-phenyl methanone (Irgacure 184), 2-hydroxy-2-methylpropiophenone (Darocure 1173) and 2-hydroxy-4'-(2-hydroxyethoxy)-2-methylpropiophenone) (Irgacure 2959). To the phosphines, 2, 4,6-trimethylbenzoyl diphenyl phosphine oxide (Lucerine TPO) belongs.

According to a preferred embodiment, said compostion comprises a combination of two initiator molecules, which preferably also comprises UV-light absorbing and scattering pigments, wherein said combination of two initiators is featured so that one initiator is activated by long wavelength light which is able to cure in the bulk, far from the surface of the printed composition, while the other one is activated at the surface as it is activated by light with a short penetration depth. In this way, effective curing in the bulk as well as at the surface is accomplished. Lucerine TPO is activated by light at longer wavelength with a long penetration depth, while for example Irgacure 2959 is mainly activated at the surface of a pigmented printed ink.

It is intended throughout the present description that the expression "pigments" embraces any pigments that may be used in an electrolyte composition, which is especially useful for printing purposes. Examples of said pigments are white titanium dioxide (TiO₂) pigments, preferably pigment particles that are passivated by an insulating layer to prevent photocatalytic reactions such as Kronos 2300, available from Kronos A/S, Norway. Another example is particles of zink oxide (ZnO).

It is intended throughout the present description that the expression "plasticizers" embraces any plasticizers that may be added to the printable composition to provide flexibility to the cured film. A plasticizer (or softener) is used to maintain and enhance the printing quality as it helps the polyelectrolyte to flow better and gives a smoother surface layer. A plasticizer may be selected among polyols with a low melting point and with a high boiling point. Examples of plasticizers are glycerol, diglycerol and polyglycerol. Other examples when it comes to plasticizers are flexible polyethers, such as polyethylene glycol and polypropyleneglycol and copolymers thereof. Said plasticizers may be external. If external, said plasticizers may preferably be random co-polymers of polyethyleneglycol and polypropyleneglycol, such as poly(ethylene glycol-ran-propylene glycol) supplied by Merck.

It is intended throughout the present description that the expression "accelerators" embraces any accelerators that may be added to the printable composition to enhance the formation of a printable composition as set out above. The accelerator is preferably a hydroxyl amine. An example of a such amine is triethanol amine which also is preferred in the context of the present invention.

According to a preferred embodiment of the first and the second aspect the polyelectrolyte is a quaternary cationic polyelectrolyte, preferably PDADMAC, most preferred a low molecular PDADMAC, especially preferred an ultra-low molecular PDADMAC (with an average M_{w} under 100000), and/or wherein the diol is a diol that has a carbon chain length of from 2 to 5, preferably propylene glycol.

The composition according to the second aspect of the present invention may also comprise additional components, such as agents that may improve the compatibility between the glycolic solvent and polycations and pigment particles. Such compatibilizing agents can include hydroxycarboxylic acids, dihydroxy carboxylic acids and polyhydroxycarboxylic acids or combinations thereof. Said compatibilizing agents may have one, two or more hydroxyl groups. The carboxylic acid may interact with a polycation or a metal oxide pigment, and the hydroxyl groups may interact with the diols according to the first aspect of the present invention. Said carboxylic acid, dihydroxy carboxylic acids and polyhydroxycarboxylic acids may have a carbon chain length of from 3 to 18. A non-limiting example of a hydroxycarboxylic acid is 3-hydroxybutyric acid, further an example of a dihydroxy carboxylic acid is 2,2-bis(hydroxymethyl)butyric acid, and finally an example of a polyhydroxy carboxylic acid is 3-hydroxy-2,2-bis(hydroxymethyl)propanoic acid. Preferably said agent for use in the context of the present invention, i.e. for improving compatibility, is 3-hydroxybutyric acid.

### Brief description of the drawings

Figure 1 discloses a cell wherein the printable composition is applied in a vertical cell. It is seen from the top.
Figure 2 is a side view of the embodiment illustrated in Fig. 1.

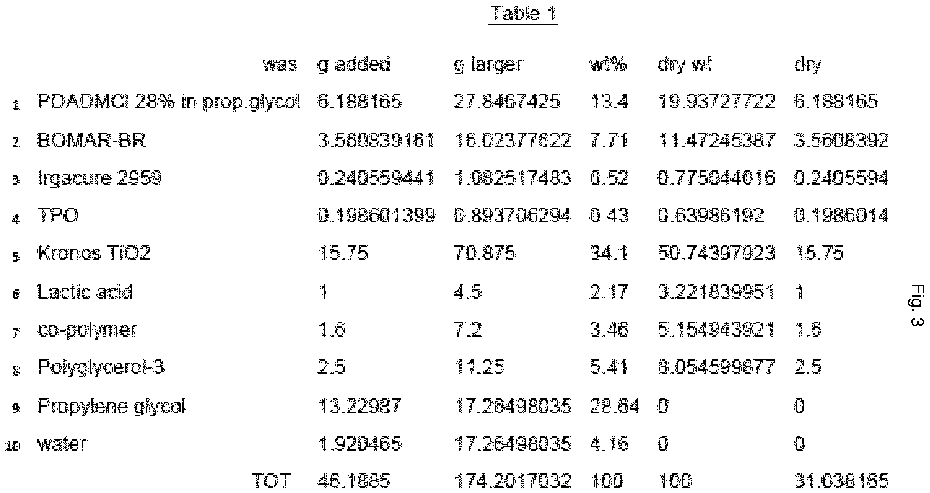

Figure 3 discloses table 1 with components of a printable composition according to the present invention which appears in Example 5.

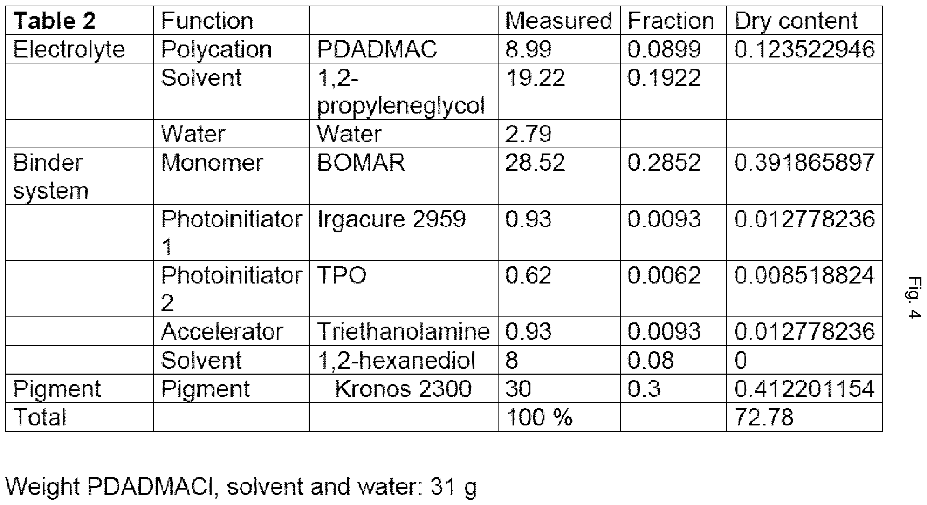

Figure 4 discloses table 2 with components of a printable composition according to the present invention which appears in Example 6.
Figure 5a discloses a topographic image of an ink made from a prior art composition as set out in the example part (example 8). Figures 5b and 5c shows images of the ink based on an intermediate composition of the present invention.
Figure 6 discloses calculated remaining solvent (water) from clothes wetted with the intermediate composition according to the present invention (IC), which is depicted by diamonds, and a prior art composition, (PA), depicted by circles (further highlighted in Example 9).
Figure 7 discloses vials containing a prior art (PA) composition as set out in the example part (example 10), to the left, and an intermediate composition according to the present invention (IC) of the present invention, after addition of DBE-3.

### Detailed description of the invention

In the following, non-limiting examples of how the compositions may be made are given. Also the following, non-limiting examples describe how the compositions may be used. Further, in the following, non-limiting examples, measurements are presented.

### Examples

### Example 1.

To 100 g of a 35 % (wt) solution of PDADMAC in water was added 90 g of propylene glycol. The mixture was evaporated until the flask contains 120 g of PDADMAC solution. The mixture contained less than 9 ±1 %of water as determined by weighing, IR-spectroscopy and Karl-Fisher titration.

### Example 2.

33.25 g of a 35% (wt) solution of PDADMAC in water was frozen and attached to a freeze dryer. The freeze drying was performed during 24h. The resulting solid mass, 11.64 g, was dissolved in 29.92 g propylene glycol.

### Example 3.

2000 g of a 35% (wt) solution of PDADMAC was mixed with 2500 g of propylene glycol and placed in 5 I plastic canister. The canister was attached to the feed inlet of an automatic rotary evaporator. The drain outlet for solvent exchanged PDADMAC solution was attached to a second plastic canister, and a third canister was connected to the condensate outlet for water collection.

### Example 4.

In this example a printable composition based on solvent exchanged PDADMAC as set out in example 1 and 3 was made. For a 100 g final electrolyte mixture, 32.48 g of PDADMAC in propylene glycol and water (29 wt%) was added to 0.667g of photo initiator Irgacure 2959, 0.467 g of photo initiator Lucirin TPO, 20.64 g of oligomer BOMAR XR-9416, 3.10 g 1,2-hexanediol and 11.61 g of external softener poly(ethylene glycol-ran-propylene glycol). The ingredients were spun at 70°C for 15 min in darkness, after which 45.74 g of pigment TiO2 Kronos 2300, available from Kronos A/S, Norway, was added to the solution. The pigment and the solution were first mixed by hand, then thoroughly mixed with a shear force modulator at 1300 - 4000 rpm for 10 min to disperse the pigment. Said composition is of the UV-curable type.

### Example 5.

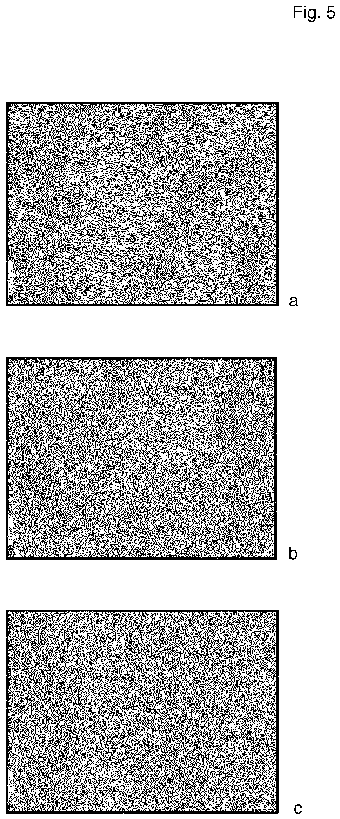

Also in this example a printable composition acccording to the present invention was made. Its components are to be found in the appended Fig 5. containing table 1.

### Example 6.

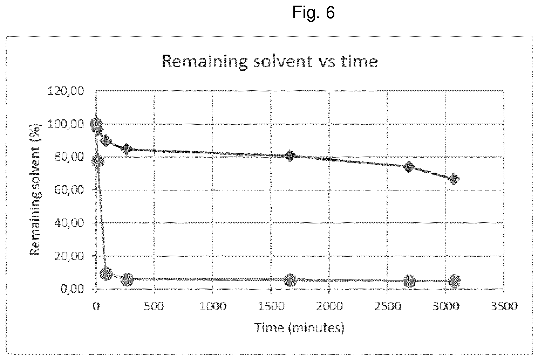

Also in this example a printable composition was made according to the present invention. Its components are to be found in the appended Fig 6. containing table 2.

### Example 7.

In this example a printable composition based on solvent exchanged PDADMAC from example 1 was made. For a 100 g final electrolyte mixture, 22.59 g of PDADMAC in propylene glycol and water (29 wt%) was added to 4.29 g of a mixture of polyvinyl butyral in DBE-3 dibasic ester (25 wt%). The ingredients were mixed with a shear force modulator at 800 rpm for 2 minutes, after which 73.12 g of pigment TiO2 Kronos 2300 was added. The ink was first mixed by hand, then thoroughly mixed with a shear force modulator at 1300 - 4000 rpm for 10 min to disperse the pigment. Said composition is of the solvent drying type.

In the following examples 8, 9 and 10 that have been made, there will be shown advantages of the intermediary composition according to the present invention, and inks based on it, compared to prior art compositions.

The intermediate composition of the invention, a solution of PDADMAC in propylene glycol and water as a minority component, was compared (also in a form of an ink) with different compositions involving PDADMAC dissolved in water (which will be further highlighted in the examples 8 to 10). The Importance of leveling, surface roughness and drying time were highlighted through these experiments as set out in examples 8 to 10.

Leveling is a process whereby patterns left in the printing process, for example from the mesh in screen printing, are leveled and smoothened out. The effect of leveling is to produce a surface that is smoother than before the leveling. This affects graphical appearance such as gloss. The process of leveling is of high importance in functional and electronic devices. In a printed electronic device, the thickness of a dielectric or electrolyte, and the thickness variations are crucial for the device properties. Even more important for electronic devices are pinholes. Presence of a pin-hole in a dielectric or an electrolyte can lead to a short-circuit between the electrodes and can be fatal for the device performance. Leveling can to some extent act to heal pinholes. Leveling is improved if the surface tension of ink is low, and if the components of a multiphase ink have similar surface tension. If a multiphase ink contains phases with different surface tension, the difference in surface tension can actually create pin-holes, so called fish eyes.

### Example 8.

A comparison of leveling in printed inks based on a prior art composition and inks based on the intermediate composition of the invention was done. Topographic images of inks based on the invention and inks based on prior art, after screen printing and curing, were recorded using optical profilometry. Values of the surface roughness were calculated from the images. In all images, topographic features can be seen. These originates from the screen printing process and are likely patterns left by the screen mesh. It can be seen that the images of the inks based on the inventions exhibits smoother features than the ink based on prior art. The values of the surface roughness are also lower for the ink based on the invention than for the ink based on prior art.

Figure 5a shows the topographic image of an ink made from the prior art composition (Example 3 in WO2013/068185). Figure 5b and 5c show images of the ink based on the intermediate composition according to the present invention (as set out in example 4). The surface roughness calculated from figure are shown in table 3. Without being bound to any theory, the improved leveling is assumed to be due to lower surface tension, and a narrower distribution of surface tensions of the ink components, and longer drying time in inks based on the intermediate composition.

**Table 3. Surface roughness (Ra) measured by optical profilometry**

| Sample | Ra (nm) |
|---|---|
| a | 886.4 |
| b | 549.4 |
| c | 312.0 |

### Example 9.

Premature drying of ink in the screen printing web may cause problems in the printing process. Dried particles may for example clog the mesh and result in pin-holes. Slow solvent evaporation also makes the ink more stable during its working time during a printing operation. A slower drying time also extends the time available for leveling between printing and drying.

In this example it was monitored the amount of remaining solvent of the intermediate composition of the present invention (as reflected by example 1 and 3 above) and an aqueous solution of PDADMAC (according to prior art, in particular the solution was made up by 23 % PDADMAC and 77 % water. Originally it was a 35 % PDADMAC solution which had been diluted with water) of the same concentration upon drying at ambient temperature in air of comparable samples. More specifically, two similar sized patches of fabric were wetted by similar amounts of the intermediate composition and the aqueous composition (according to prior art set out above). The weight of the patches were measured as a function of time after wetting with fresh solution, and from the values, the percentage of remaining solvent amount was calculated and plotted against time. Thus the drying time for the intermediate composition, according to the present invention, and the prior art composition were compared.

To obtain a similar geometry of evaporation for the liquids, similar amounts of the compositions were soaked into pieces of fabric of similar size and the weight of the soaked fabrics were measured at intervals of time. From the weight values, calculated values of remaining solvent were obtained, tabulated and plotted in a diagram.

As can be seen, the prior art composition quickly loses most of the solvent and less than 10% solvent remains after 84 minutes, while the intermediate is calculated to retain 89 % of the solvent after 84 minutes. After 3077 minutes, or more than two days, more than 66 % solvent remained. This exemplifies the lower overall drying rate of solvent from the intermediate composition compared to the prior art composition.

**Table 4. calculated remaining solvent after drying time (also depicted in Figure 6)**

| Time/min | | |
|---|---|---|
| | I.C.* | P.A.** |
| 0 | 100.00 | 100.00 |
| 14 | 96.79 | 77.61 |
| 84 | 89.58 | 9.35 |
| 264 | 84.63 | 5.99 |
| 1663 | 80.64 | 5.62 |
| 2690 | 74.04 | 4.99 |
| 3077 | 66.58 | 4.90 |

| | | |
|---|---|---|
| *I.C.= Intermediate composition according to the present invention **P.A.=composition according to prior art | | |

### Example 10.

Compatibility with organic compounds is also important for printable compositions. Organic compounds such as molecules in binder systems, polymerizable molecules and polymerization initiators, stabilizers and plasticizers often need to be included in the composition, something that is difficult for state-of-the art compositions, i.e. highly aqueous polyelectrolyte solutions.

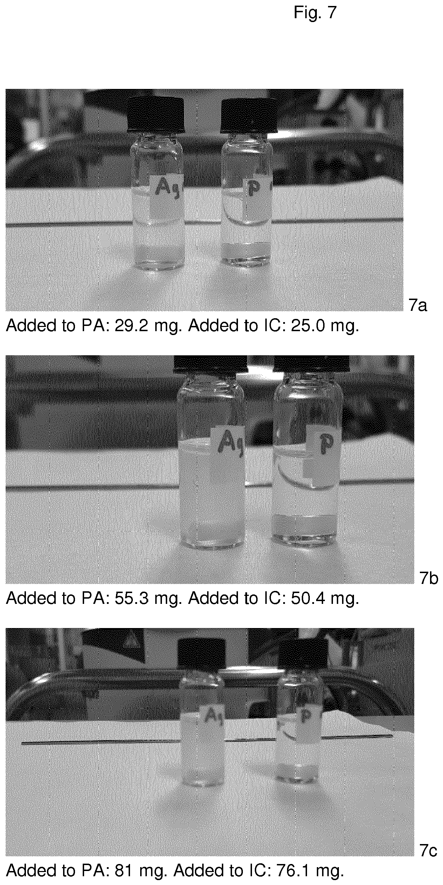

In this example it was added an organic solvent, dibasic ester 3, DBE-3 to the prior art composition and the intermediate composition according to the present invention (as reflected by examples 1 and 3 above), respectively, and the solubility was judged by the clarity of the mixture (the results are reflected in Figure 7 (7a , 7b and 7c). If the mixture appeared clear by occular observation, the organic solvent was judged soluble. Presence of a separated phase and loss of visual clarity indicated that the concentration of added solvent was above the solubility limit.

The following results could be observed:
Aq (a composition according to prior art):
   2.50 g, turbidity already after addition of 29.2 mg (see Figure 7a)
IC (intermediate composition according to the present invention):
   2.509 g, no turbidity was observed even after addition of 238 mg. Turbidity was observed after addition of 292.8 mg.

Thus there was a comparison done of compatibility of the intermediate composition according to the present invention and a prior art composition (the prior art composition was made up by 23 % PDADMAC and 77 % water. Originally it was a 35 % PDADMAC solution which had been diluted with water) with dibasic ester 3 (DBE-3) and to 2.500 g of prior art composition, with 23 wt% PDADMAC in water, was added one drop (29.2 mg) of DBE-3. Even after prolonged agitation, the turbidity remained. Agitation of the mixture formed a turbid suspension demonstrating the incompatibility of DBE-3 with the prior art composition. This shows that the solubility of DBE-3 in the prior art composition was less than 1.15 wt%. To 2.509 g of the intermediate composition according to the present invention, DBE-3 was added drop-wise. After each addition, the mixture was agitated for 10 minutes after which the mixture was inspected ocularly for clarity or turbidity. After addition of 238 mg DBE-3, a clear homogenous solution was obtained. This means that the solubility of the intermediate composition was more than 8.67 wt%.

### Example 11

Saturation of intermediate compositions obtained by solvent exchange.

When solvent exchanged intermediate composition obtained according to example 1, contains less than approximately 9 wt% water, a phase separation may occur. When a precipitate is formed from a 23% solvent exchanged solution, it was taken out. It could be dissolved in water, but not in propylene glycol. This phase separation may occur as a cloudiness or small droplets, a heavy liquid phase forming at the bottom of the storage vessel. When water is added to a bottom fraction containing said heavy phase, the mixture becomes a clear single phase solution again. Without being bound by any therory it is therefore assumed that the heavy phase represents a water-rich solution of the polyelectrolyte. It could also be noted that in absence of water, in intermediate compositions obtained from freeze-dried samples such as disclosed in example 2 above, phase separation did not occur.

In the following, embodiments of the present invention will be discussed with reference to the accompanying figures. It should be noted that this detailed description by no means limits the scope of the invention. The scope of the invention is defined by the appended claims. Further, that specific features are mentioned in connection to an embodiment of the invention does not mean that those features cannot be used to an advantage together with other embodiments of the invention.

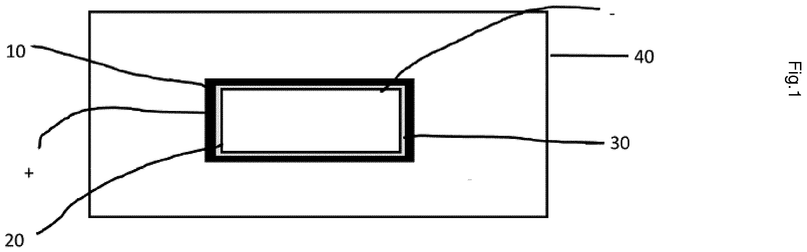

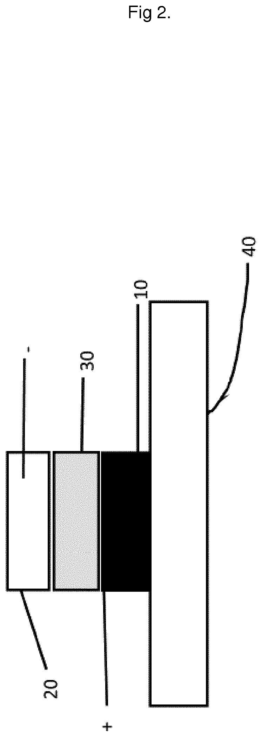

Figure 1 discloses as said above a cell wherein the printable composition is applied in a vertical cell which is seen from the top. The cell comprises a first electronically conductive layer 10 (being a first electrode). Then there is a second ionically conductive layer 30 (being the printable composition). Additionally, there is a third layer electronically conductive 20 (being a second electrode). The relative breadth, width and height of said layers may vary, and they may have any size as long as the electronically conductive layers normally avoid being in direct contact with each other. When operated a first potential (+) is applied to the first layer serving as the first electrode; a second potential (-), different from said first potential, is applied to the third layer serving as the second electrode. In the figure there is also a substrate shown (40) on which the first, second and third layers, respectively, are positioned. This is further illustrated in the side view of the cell which is apparent from figure 2. Analogously, said printable composition may be used for lateral cell structures in a smaller scale. There may also be more than two electrodes present in said embodiment as set out in figures 1 and 2, and also in a lateral cell structure in a smaller scale as mentioned above. Thus in addition to the electrodes appearing at the bottom and at the top, there may be one or more additional electrodes. Consequently e.g. a transistor structure is also plausible.

Preferred features of each aspect of the invention are as for each of the other aspects mutatis mutandis. The skilled person knows how to design and operate such electrochemical cells/devices (as e.g. depicted in Figures 1 - 2) and also such electrochemical cells/devices as set out in the prior art document (s) mentioned herein.

## Claims

1. A process for manufacturing a printable composition comprising the following steps:
I) providing an aqueous solution of one or more polyelectrolytes, wherein the polyelectrolyte is a quaternary cationic polyelectrolyte, preferably PDADMAC, most preferred a low molecular PDADMAC, especially preferred an ultra-low molecular PDADMAC,
II) mixing one or more diols with said aqueous solution, wherein preferably the diol is a diol that has a carbon chain length of from 2 to 5, preferably propylene glycol,
III) removing water either before or after step II), wherein the water removal is achieved preferably through evaporation, solvent exchanging or freeze-drying or a combination thereof, thus providing and intermediary composition,
wherein the water content of the printable composition is from 0.001 to 15% (w/w), preferably from 0.01 to 12 % (w/w), most preferred from 0.1 to 10 % (w/w), especially preferred from 1 to 7 % (w/w).

2. A process, according to claim 1, wherein only steps I, II and III are performed thereby providing an intermediary composition, further comprising the step of adding and mixing one or more additional components to said intermediary composition, wherein said components are selected from the group:
- polymerizable molecules,
- initiator molecules,
- processing aid agents,
- pigments,
- plasticizers,
- accelerators,
- solvent drying binders, and
- compatibilizing agents.

3. A process, according to claim 1 or 2, wherein the composition after having one or more additional components added, besides one or more polyelectrolytes, one or more diols and water, has a water content from 2 to 6 % (w/w).

4. A printable composition comprising
a) one or more polyelectrolytes, wherein the polyelectrolyte is a quaternary cationic polyelectrolyte, most preferred PDADMAC, especially preferred a low molecular PDADMAC, particularly preferred an ultra-low molecular PDADMAC,
b) one or more diols, preferably a diol that has a carbon chain length of from 2 to 5, most preferred a propylene glycol, and
c) water, wherein said water content of said composition is from 0.001 to 15% (w/w), preferably from 0.01 to 12 % (w/w), most preferred from 0.1 to 10 % (w/w), especially preferred from 1 to 7 % (w/w).

5. The composition according to claim 4 wherein the one or more polyelectrolytes is present in a range from 5 to 50 %, preferably 28 to 30 % (w/w) and/or the one or more diols is present in a range from 50 to 95 %, preferably 60 to 70 % (w/w).

6. The composition according to claim 4 or 5 also comprising:
d) a hydroxyl carboxylic acid, preferably a hydroxyl carboxylic acid with a carbon chain of from 1 to 6, and wherein said hydroxyl carboxylic acid, is optionally selected from the group comprising 2-hydroxy-2-methylbutyric acid, 2,2-bis (hydroxymethyl) butyric acid or a combination thereof.

7. The composition according to any one of claims 4 to 6 also comprising:
e) one or more curing enhancing agents, preferably selected from the group comprising one or more solvent drying binders, one or more polymerizable molecules and one or more initiator molecules.

8. The composition according to claim 7, wherein said one or more curing enhancing agents is (are) either:
f) one or more solvent drying binders, preferably a polyvinyl butyral, most preferred a polyvinyl butyral with a low molecular weight, or
g)
- two or more polymerizable molecules, and
- one or more initiator molecules.

9. A composition according to claim 8 further comprising a processing aid agent, which preferably is an aliphatic carboxylic acid with a low melting point, most preferred lactic acid, especially preferred DL-lactic acid.

10. A composition according to claim 8 or 9 further comprising:
- one or more pigments, and/or
- one or more plasticizers, and/or
- one or more accelerators, wherein said accelerator preferably is triethanolamine.

11. A composition according to claim 8, 9 or 10 wherein the polymerizable molecules are polyether (meth-) acrylates or urethane (meth-) acrylates or a combination thereof.

12. A composition according to claim 8, 9, 10 or 11 wherein the one or more initiator molecules is selected form the group consisting of 2-hydroxy-4'-(2-hydroxyethoxy)-2-methylpropiophenone), 2, 4,6-trimethylbenzoyl diphenyl phosphine oxide or difunctional - α-hydroxy ketone or combinations thereof.

13. A process for the manufacture of an electrochemical cell comprising the following steps:
providing a first electrode (10); a second electrode (20); and a printable composition according to any one of claims 4-12, wherein the printable composition is arranged in ionic contact with both said first and second electrode, and
wherein the first electrode, the second electrode and/or the printable composition is preferably provided by means of printing.

14. Use of a printable composition according to any one of claims 4 - 12 for printing an electrolyte layer in ionic contact with at least a first electrode (10) and a second electrode (20) in an electrochemical cell.

15. An electrochemical cell, comprising a first and a second electrode and an electrolyte layer in ionic contact with both said first and second electrodes, wherein said electrolyte layer comprises a printable composition according to any one of claims 4 - 12.

## Patentansprüche

1. Verfahren zur Herstellung einer druckbaren Zusammensetzung, welches folgende Schritte umfasst:
I) Bereitstellen einer wässrigen Lösung von einem oder mehreren Polyelektrolyten, wobei der Polyelektrolyt ein quaternärer kationischer Polyelektrolyt ist, vorzugsweise PDADMAC, am bevorzugtesten ein niedermolekulares PDADMAC, besonders bevorzugt ein ultra-niedermolekulares PDADMAC,
II) Mischen von einem oder mehreren Diolen mit der wässrigen Lösung, wobei das Diol vorzugsweise ein Diol ist, das eine Kohlenstoffkettenlänge von 2 bis 5 aufweist, vorzugsweise Propylenglykol,
III) Entfernen von Wasser entweder vor oder nach Schritt II), wobei die Wasserentfernung vorzugsweise durch Verdunstung, Lösemittelaustausch oder Gefriertrocknung oder eine Kombination davon erreicht wird, wodurch eine intermediäre Zusammensetzung bereitgestellt wird,
wobei der Wassergehalt der druckbaren Zusammensetzung von 0,001 bis 15 % (w/w), vorzugsweise von 0,01 bis 12 % (w/w), am bevorzugtesten von 0,1 bis 10 % (w/w), besonders bevorzugt von 1 bis 7 % (w/w) beträgt.

2. Verfahren nach Anspruch 1, wobei nur Schritt I, II und III durchgeführt werden, wodurch eine intermediäre Zusammensetzung bereitgestellt wird, welches ferner den Schritt des Zugebens und Mischens von einer oder mehreren zusätzlichen Komponenten zu der intermediären Zusammensetzung umfasst, wobei die Komponenten ausgewählt sind aus der folgenden Gruppe:
- polymerisierbare Moleküle,
- Initiatormoleküle,
- Verarbeitungshilfsmittel,
- Pigmente,
- Weichmacher,
- Beschleuniger,
- Lösemittel-trocknende Bindemittel, und
- Kompatibilisierungsmittel.

3. Verfahren nach Anspruch 1 oder 2, wobei die Zusammensetzung, nachdem eine oder mehrere zusätzliche Komponenten zugegeben wurden, neben einem oder mehreren Polyelektrolyten, einem oder mehreren Diolen und Wasser, einen Wassergehalt von 2 bis 6 % (w/w) aufweist.

4. Druckbare Zusammensetzung, welche Folgendes umfasst:
a) einen oder mehrere Polyelektrolyte, wobei der Polyelektrolyt ein quaternärer kationischer Polyelektrolyt ist, am bevorzugtesten PDADMAC, besonders bevorzugt ein niedermolekulares PDADMAC, insbesondere bevorzugt ein ultra-niedermolekulares PDADMAC,
b) ein oder mehrere Diole, vorzugsweise ein Diol, das eine Kohlenstoffkettenlänge von 2 bis 5 aufweist, am bevorzugtesten ein Propylenglykol, und
c) Wasser, wobei der Wassergehalt der Zusammensetzung von 0,001 bis 15 % (w/w), vorzugsweise von 0,01 bis 12 % (w/w), am bevorzugtesten von 0,1 bis 10 % (w/w), besonders bevorzugt von 1 bis 7 % (w/w) beträgt.

5. Zusammensetzung nach Anspruch 4, wobei der eine oder die mehreren Polyelektrolyte in einem Bereich von 5 bis 50 %, vorzugsweise 28 bis 30 % (w/w) vorliegen und/oder das eine oder die mehreren Diole in einem Bereich von 50 bis 95 %, vorzugsweise 60 bis 70 % (w/w) vorliegen.

6. Zusammensetzung nach Anspruch 4 oder 5, welche auch Folgendes umfasst:
d) eine Hydroxylcarbonsäure, vorzugsweise eine Hydroxylcarbonsäure mit einer Kohlenstoffkette von 1 bis 6, und wobei die Hydroxylcarbonsäure wahlweise ausgewählt ist aus der Gruppe umfassend 2-Hydroxy-2-methylbuttersäure, 2,2-Bis(hydroxymethyl)buttersäure oder eine Kombination davon.

7. Zusammensetzung nach einem der Ansprüche 4 bis 6, welche auch Folgendes umfasst:
e) ein oder mehrere härtungsverstärkende Mittel, vorzugsweise ausgewählt aus der Gruppe umfassend ein oder mehrere Lösemittel-trocknende Bindemittel, ein oder mehrere polymerisierbare Moleküle und ein oder mehrere Initiatormoleküle.

8. Zusammensetzung nach Anspruch 7, wobei das eine oder die mehreren härtungsverstärkende(n) Mittel entweder:
f) ein oder mehrere Lösemittel-trocknende Bindemittel, vorzugsweise ein Polyvinylbutyral, am bevorzugtesten ein Polyvinylbutyral mit einem niedrigen Molekulargewicht, oder
g)
- zwei oder mehr polymerisierbare Moleküle, und
- ein oder mehrere Initiatormoleküle ist (sind).

9. Zusammensetzung nach Anspruch 8, welche ferner ein Verarbeitungshilfsmittel umfasst, wobei es sich vorzugsweise um eine aliphatische Carbonsäure mit einem niedrigen Schmelzpunkt handelt, am bevorzugtesten Milchsäure, besonders bevorzugt DL-Milchsäure.

10. Zusammensetzung nach Anspruch 8 oder 9, welche ferner Folgendes umfasst:
- ein oder mehrere Pigmente, und/oder
- einen oder mehrere Weichmacher, und/oder
- einen oder mehrere Beschleuniger, wobei der Beschleuniger vorzugsweise Triethanolamin ist.

11. Zusammensetzung nach Anspruch 8, 9 oder 10, wobei die polymerisierbaren Moleküle Polyether(meth-)acrylate oder Urethan(meth-)acrylate oder eine Kombination davon sind.

12. Zusammensetzung nach Anspruch 8, 9, 10 oder 11, wobei das eine oder die mehreren Initiatormoleküle ausgewählt sind aus der Gruppe bestehend aus 2-Hydroxy-4'-(2-hydroxyethoxy)-2-methylpropiophenon), 2,4,6-Trimethylbenzoyldiphenylphosphinoxid oder difunktionellem α-Hydroxyketon oder Kombinationen davon.

13. Verfahren zur Herstellung einer elektrochemischen Zelle, welches die folgenden Schritte umfasst:
Bereitstellen einer ersten Elektrode (10); einer zweiten Elektrode (20); und einer druckbaren Zusammensetzung nach einem der Ansprüche 4-12, wobei die druckbare Zusammensetzung in ionischem Kontakt mit sowohl der ersten als auch der zweiten Elektrode angeordnet ist, und
wobei die erste Elektrode, die zweite Elektrode und/oder die druckbare Zusammensetzung vorzugsweise mittels Drucken bereitgestellt werden.

14. Verwendung einer druckbaren Zusammensetzung nach einem der Ansprüche 4-12 zum Drucken einer Elektrolytschicht in ionischem Kontakt mit mindestens einer ersten Elektrode (10) und einer zweiten Elektrode (20) in einer elektrochemischen Zelle.

15. Elektrochemische Zelle, welche eine erste und eine zweite Elektrode und eine Elektrolytschicht in ionischem Kontakt mit sowohl der ersten als auch der zweiten Elektrode umfasst, wobei die Elektrolytschicht eine druckbare Zusammensetzung nach einem der Ansprüche 4-12 umfasst.

## Revendications

1. Procédé pour la fabrication d'une composition imprimable comprenant les étapes suivantes :
I) la fourniture d'une solution aqueuse d'un ou plusieurs polyélectrolytes, dans lequel le polyélectrolyte est un polyélectrolyte cationique quaternaire, de préférence du PDADMAC, de manière la plus préférée, un PDADMAC faiblement moléculaire, de manière particulièrement préférée, un PDADMAC ultra-faiblement moléculaire,
II) le mélange d'un ou plusieurs diols avec ladite solution aqueuse, dans lequel le diol est de préférence un diol qui a une longueur de chaîne de carbone de 2 à 5, de préférence du propylène glycol,
III) le retrait d'eau avant ou après l'étape II), dans lequel le retrait d'eau est de préférence obtenu par évaporation, échange de solvant ou lyophilisation ou une combinaison de cela, en fournissant ainsi une composition intermédiaire,
dans lequel la teneur en eau de la composition imprimable est de 0,001 à 15% (w/w), de préférence de 0,01 à 12% (w/w), de manière la plus préférée, de 0,1 à 10% (w/w), de manière particulièrement préférée, de 1 à 7% (w/w).

2. Procédé selon la revendication 1, dans lequel seulement les étapes I, Il et III sont réalisées en fournissant ainsi une composition intermédiaire, comprenant en outre l'étape d'ajout d'un ou plusieurs composants à ladite composition intermédiaire et de mélange avec celle-ci, dans lequel lesdits composants sont sélectionnés dans le groupe suivant :
- des molécules polymérisables,
- des molécules d'initiateur,
- des agents auxiliaires de traitement,
- des pigments,
- des plastifiants,
- des accélérateurs,
- des liants de séchage de solvants, et
- des agents de compatibilité.

3. Procédé selon la revendication 1 ou 2, dans lequel la composition, après y avoir ajouté un ou plusieurs composants supplémentaires, possède, mis à part un ou plusieurs polyélectrolytes, un ou plusieurs diols et de l'eau, une teneur en eau de 2 à 6% (w/w).

4. Composition imprimable comprenant
a) un ou plusieurs polyélectrolytes, dans laquelle le polyélectrolyte est un polyélectrolyte cationique quaternaire, de manière la plus préférée, du PDADMAC, de manière spécialement préférée, un PDADMAC faiblement moléculaire, de manière particulièrement préférée, un PDADMAC ultra-faiblement moléculaire,
b) un ou plusieurs diols, de préférence un diol ayant une longueur de chaîne de carbone de 2 à 5, de manière la plus préférée, un propylène glycol, et
c) de l'eau, dans laquelle ladite teneur en eau de ladite composition est de 0,001 à 15% (w/w), de préférence de 0,01 à 12% (w/w), de manière la plus préférée, de 0,1 à 10% (w/w), de manière particulièrement préférée, de 1 à 7% (w/w).

5. Composition selon la revendication 4, dans laquelle ce ou ces polyélectrolytes sont présents selon une plage de 5 à 50%, de préférence de 28 à 30% (w/w) et/ou ce ou ces diols sont présents selon une plage de 50 à 95%, de préférence de 60 à 70% (w/w).

6. Composition selon la revendication 4 ou 5, comprenant en outre :
d) de l'acide hydroxycarboxylique, de préférence un acide hydroxycarboxylique avec une chaîne de carbone de 1 à 6, et dans laquelle ledit acide hydroxycarboxylique est sélectionné en option dans le groupe comprenant de l'acide 2-hydroxy-2-méthylbutyrique, de l'acide 2,2-bis(hydroxyméthyl)butyrique ou une combinaison de ceux-ci.

7. Composition selon l'une quelconque des revendications 4 à 6 comprenant également :
e) un ou plusieurs agents d'amélioration de durcissement, de préférence sélectionnés dans le groupe comprenant un ou plusieurs liants de séchage de solvant, ou une ou plusieurs molécules polymérisables et une ou plusieurs molécules d'initiateur.

8. Composition selon la revendication 7, dans laquelle ce ou ces agent(s) d'amélioration de durcissement est (sont) l'un ou l'autre parmi
f) un ou plusieurs liants de séchage de solvant, de préférence un polyvinyl butyral, de manière la plus préférée, un polyvinyl butyral avec un faible poids moléculaire, ou
g)
- deux ou davantage de molécules polymérisables, et
- une ou plusieurs molécules d'initiateur.

9. Composition selon la revendication 8, comprenant en outre un agent auxiliaire de traitement qui est de préférence de l'acide aliphatique carboxylique avec un point de fusion bas, de manière la plus préférée, de l'acide lactique, de manière spécialement préférée, de l'acide DL-lactique.

10. Composition selon la revendication 8 ou 9, comprenant en outre :
- un ou plusieurs pigments, et/ou
- un ou plusieurs plastifiants, et/ou
- un ou plusieurs accélérateurs, dans laquelle ledit accélérateur est de préférence de la triéthanolamine.

11. Composition selon la revendication 8, 9 ou 10, dans laquelle les molécules polymérisables sont des polyéther(méth)acrylates ou des uréthane(méth)acrylates ou une combinaison de ceux-ci.

12. Composition selon la revendication 8, 9, 10 ou 11, dans laquelle cette ou ces molécule(s) d'initiateur est/sont sélectionnée(s) dans le groupe constitué de 2-hydroxy-4'-(2-hydroxyéthoxy)-2-méthylpropiophénone), 2,4,6-triméthylbenzoyl diphényl phosphine oxyde ou d'une α-hydroxy cétone difonctionnelle, ou des combinaisons de ceux-ci.

13. Procédé de fabrication d'une cellule électrochimique comprenant les étapes suivantes :
la fourniture d'une première électrode (10) ; d'une deuxième électrode (20) ; et d'une composition imprimable selon l'une quelconque des revendications 4-12, dans lequel la composition imprimable est disposée en contact ionique à la fois avec ladite première et ladite deuxième électrode, et
dans lequel la première électrode, la deuxième électrode et/ou la composition imprimable est de préférence fournie au moyen d'une impression.

14. Utilisation d'une composition imprimable selon l'une quelconque des revendications 4-12 pour l'impression d'une couche d'électrolyte en contact ionique avec au moins une première électrode (10) et une deuxième électrode (20) dans une cellule électrochimique.

15. Cellule électrochimique, comprenant une première et une deuxième électrode et une couche d'électrolyte en contact ionique à la fois avec lesdites première et deuxième électrodes, dans laquelle ladite couche d'électrolyte comprend une composition imprimable selon l'une quelconque des revendications 4-12.
